(19) **Europäisches Patentamt / European Patent Office / Office européen des brevets**

(11) **EP 4 660 641 A1**

(12) **DEMANDE DE BREVET EUROPEEN**

(43) Date de publication:
**10.12.2025 Bulletin 2025/50**

(21) Numéro de dépôt: **25180627.9**

(22) Date de dépôt: **04.06.2025**

(51) Classification Internationale des Brevets (IPC):
**G01R 29/08** $^{(2006.01)}$     **G01R 35/00** $^{(2006.01)}$

(52) Classification Coopérative des Brevets (CPC):
**G01R 29/0821; G01R 35/005**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **04.06.2024 FR 2405845**

(71) Demandeur: **Commissariat à l'Energie Atomique et aux Energies Alternatives
75015 Paris (FR)**

(72) Inventeurs:
- **MUNOZ, Frédéric
  38054 Grenoble Cedex 9 (FR)**
- **PINTOS, Jean-François
  38054 Grenoble Cedex 9 (FR)**
- **BORIES, Serge
  38054 Grenoble Cedex 9 (FR)**

(74) Mandataire: **Lavoix
2, place d'Estienne d'Orves
75441 Paris Cedex 09 (FR)**

(54) **PROCÉDÉ DE CARACTÉRISATION D'UNE CHAMBRE ANÉCHOÏQUE ET DISPOSITIFS ASSOCIÉS**

(57)     La présente invention concerne un procédé de caractérisation d'une chambre anéchoïque (10), le procédé comprenant une étape de :
- pour plusieurs points de mesure spatialement agencés selon un cercle, acquisition d'un signal),
- conversion des signaux acquis en composantes, chaque composante étant la valeur d'un ordre respectif de la décomposition de la somme des signaux acquis en modes de phase,
- filtrage de chaque composante par application d'un filtre de compensation éliminant la dépendance en fréquence,
- estimation de l'amplitude et de la direction d'arrivée de diffuseurs parasites par résolution d'un système d'équations selon lequel chaque composante filtrée est égale à une somme de contributions des diffuseurs parasites, chacune dépendant de l'amplitude et de la direction d'arrivée du diffuseur, et
- détermination du paramètre de caractérisation à partir des amplitudes et des directions d'arrivée estimées

FIG.1

EP 4 660 641 A1

**Description**

La présente invention concerne un procédé de caractérisation d'une partie d'une chambre anéchoïque. La présente invention se rapporte également à des dispositifs associés, à savoir un dispositif de détermination d'au moins un paramètre de caractérisation de la partie, un système de caractérisation de la partie et à une chambre anéchoïque.

Une chambre anéchoïque (ou chambre anéchoïde) est un espace spécialement conçu pour émuler la propagation d'une onde en espace libre. L'espace est délimité par des parois métalliques ou non. Chaque paroi (latérale, sol ou plafond) est tapissée de matériaux absorbants les ondes électromagnétiques. C'est le calepinage de la chambre anéchoïque. Cela permet d'avoir un environnement électromagnétique contrôlé pour tester et mesurer les performances d'antennes ou d'autres dispositifs électromagnétiques.

Il est souvent défini un volume au sein de la chambre anéchoïque dans lequel ces tests et ces mesures de performances sont à effectuer du fait que ce volume présente ondulation minimale en amplitude et en phase. Ce volume est généralement dénommé zone tranquille. L'ondulation résiduelle provient principalement de l'existence d'échos insuffisamment atténués par les absorbants.

Il est donc souhaitable de pouvoir caractériser électromagnétiquement la zone tranquille d'une chambre anéchoïque.

Il est connu d'utiliser une technique dite VSWR (pour la dénomination anglaise correspondante de « Voltage Standing Wave Ratio ») déterminant le rapport d'ondes stationnaires. Cette technique repose sur les principes de détermination des réflexions dans une ligne de transmission micro-ondes.

Cette technique suppose que les ondes directes et réfléchies se rencontrent à un point le long d'une ligne sur laquelle se déplace une sonde. Lors du déplacement de la sonde, la variation de l'amplitude du signal de réception produit un modèle VSWR, à partir duquel sa réflectivité peut être dérivée.

Cependant, un motif d'interférence mesuré dans une chambre réelle peut être beaucoup plus complexe que le modèle simple supposé par le modèle VSWR. Cela est dû au fait que l'environnement de la chambre peut violer de nombreuses hypothèses sur lesquelles repose la méthode, telles que la présence d'un nombre d'ondes cohérentes strictement supérieur à 2, une longueur de déplacement de la sonde insuffisante pour obtenir au moins une période complète (distance entre 2 max ou 2 min de la courbe) de l'ondulation d'amplitude.

De plus, cela suppose de déplacer une antenne suivant un axe de translation pour une orientation et une polarisation données de l'antenne. Un positionneur additionnel est donc ajouté, ce qui implique d'enlever partiellement ou totalement les absorbants présents sur le sol. La mesure effectuée est donc faussée, puisque le calepinage nominal de la chambre est modifié. Cette problématique est accrue lorsque la chambre anéchoïde est équipée elle-même d'un positionneur ne permettant pas aisément d'effectuer le balayage spatial souhaité par la sonde de mesure.

Il existe donc un besoin pour un procédé de caractérisation d'une partie d'une chambre anéchoïque qui soit de mise en œuvre plus aisée tout en permettant d'obtenir une caractérisation plus précise.

A cet effet, la description décrit un procédé de caractérisation d'une partie d'une chambre anéchoïque, le procédé de caractérisation comprenant :

- une phase d'acquisition comprenant :

  - pour plusieurs points de mesure dans la partie, une étape d'acquisition du signal électromagnétique reçu par un capteur positionné audit point de mesure, pour obtenir une pluralité de signaux électromagnétiques acquis, les points de mesure étant spatialement agencés selon un cercle,

- une phase de détermination d'au moins un paramètre de caractérisation de la partie à partir des signaux électromagnétiques acquis, la phase de détermination comprenant une étape de :

  - conversion des signaux électromagnétiques acquis à une fréquence donnée en un ensemble de composantes, chaque composante étant la valeur d'un ordre respectif de la décomposition de la somme des signaux électromagnétiques acquis en modes de phase,
  - filtrage de chaque composante par application d'un filtre de compensation sur chaque composante éliminant la dépendance en fréquence de la composante, pour obtenir des composantes filtrées,
  - estimation de l'amplitude et de la direction d'arrivée de chacun des diffuseurs parasites présents dans la chambre anéchoïque par résolution d'un système d'équations selon lequel chaque composante filtrée est égale à une somme de contributions des diffuseurs parasites à la valeur de la composante filtrée, la contribution d'un diffuseur parasite dépendant de l'amplitude et de la direction d'arrivée du diffuseur, pour obtenir des amplitudes estimées et des directions d'arrivée estimées, et
  - détermination de la valeur d'un paramètre de caractérisation à la fréquence donnée à partir des amplitudes estimées et des directions d'arrivée estimées.

Suivant d'autres aspects avantageux de l'invention, le procédé de caractérisation comprend une ou plusieurs des caractéristiques suivantes, prises isolément ou suivant toutes les combinaisons techniquement possibles :

- un unique capteur est utilisé lors de la mise en œuvre de la phase d'acquisition, la phase d'acquisition comportant une étape de déplacement du capteur vers chaque point de mesure.
- chaque capteur est une antenne adaptée pour recevoir des signaux s'étendant sur une bande de fréquences prédéfinie, la bande de fréquences prédéfinie étant incluse dans l'intervalle s'étendant entre 30 MHz et 3 000 MHz.
- le paramètre de caractérisation est le taux d'ondes stationnaire ou un paramètre représentatif de la réflectivité de la chambre anéchoïque.
- lors de la phase de détermination, les étapes de conversion, de filtrage, d'estimation et de détermination sont mises en œuvre pour plusieurs fréquences pour obtenir la variation en fréquence du paramètre de caractérisation.
- chaque contribution est égale au produit de l'amplitude par une exponentielle complexe dont l'argument est la direction d'arrivée.
- l'étape d'estimation comporte la mise en œuvre d'une technique de crayon matriciel pour estimer les directions d'arrivées.
- la technique de crayon matriciel implique l'emploi d'une première matrice de Henkel et d'une deuxième matrice de Henkel, la première matrice de Henkel étant telle que

$$H_1 = \begin{pmatrix} sw_{-M} & \cdots & sw_{L-1} \\ \vdots & \ddots & \vdots \\ sw_{M-L-1} & \cdots & sw_{M-1} \end{pmatrix}$$

où :

- $sw_x$ désigne la composante filtrée d'ordre x,
- M désigne l'ordre maximal des composantes obtenues à l'étape de conversion, et

    - L est le paramètre de crayon,

$$H_2 = \begin{pmatrix} sw_{-M+1} & \cdots & sw_{L} \\ \vdots & \ddots & \vdots \\ sw_{M-L} & \cdots & sw_{M} \end{pmatrix}$$

la deuxième matrice H2 étant telle que                                                      .

- la technique de crayon matriciel comporte un seuillage des valeurs de chacune des matrices de Henkel pour éliminer les valeurs présentant du bruit, les valeurs étant éliminées lorsque ces valeurs ne respectent pas une condition par rapport à un seuil prédéterminé.
- l'étape d'estimation comporte l'application d'une technique de moindre carré pour estimer les amplitudes.
- il est défini une zone tranquille pour la chambre anéchoïque, la partie caractérisée par le procédé de caractérisation étant la zone tranquille

La description concerne également un dispositif de détermination d'au moins un paramètre de caractérisation d'une partie d'une chambre anéchoïque, le dispositif de détermination étant propre à :

- obtenir, pour plusieurs points de mesure dans la partie, un signal électromagnétique acquis, chaque signal électromagnétique étant le signal électromagnétique reçu par un capteur positionné audit point de mesure, les points de mesure étant spatialement agencés selon un cercle,
- déterminer au moins un paramètre de caractérisation de la partie à partir des signaux acquis par :

    - conversion des signaux électromagnétiques acquis à une fréquence donnée en un ensemble de composantes, chaque composante étant la valeur d'un ordre respectif de la décomposition de la somme des signaux électromagnétiques acquis en modes de phase,
    - filtrage de chaque composante par application d'un filtre de compensation sur chaque composante éliminant la dépendance en fréquence de la composante, pour obtenir des composantes filtrées,
    - estimation de l'amplitude et de la direction d'arrivée de chacun des diffuseurs parasites présents dans la chambre anéchoïque par résolution d'un système d'équations selon lequel chaque composante filtrée est égale à une somme de contributions des diffuseurs parasites à la valeur de la composante filtrée, la contribution d'un diffuseur parasite dépendant de l'amplitude et de la direction d'arrivée du diffuseur, pour obtenir des amplitudes estimées et des directions d'arrivée estimées, et

- déduction de la valeur d'un paramètre de caractérisation à la fréquence donnée à partir des amplitudes estimées et des directions d'arrivée estimées.

La description décrit aussi un système de caractérisation d'une partie d'une chambre anéchoïque, le système de caractérisation comportant :

- un dispositif d'acquisition, le dispositif d'acquisition comprenant au moins un capteur, le dispositif d'acquisition étant propre à, pour plusieurs points de mesure dans la partie, acquérir un signal électromagnétique acquis, chaque signal électromagnétique étant le signal électromagnétique reçu par un capteur positionné audit point de mesure, les points de mesure étant spatialement agencés selon un cercle, et
- un dispositif de détermination, le dispositif de détermination étant tel que précédemment décrit.

La description concerne également une chambre anéchoïque pourvue d'un système de caractérisation d'une partie d'une chambre anéchoïque, te système de caractérisation étant tel que précédemment décrit.

Dans la présente description, l'expression « propre à » signifie indifféremment « adapté pour », « adapté à » ou « configuré pour ».

L'invention apparaîtra plus clairement à la lecture de la description qui va suivre, donnée uniquement à titre d'exemple non limitatif, et faite en référence aux dessins dans lesquels :

- la figure 1 est une représentation schématique en section d'une chambre anéchoïque ou anéchoïde munie d'un système de caractérisation d'une partie de la chambre anéchoïque,
- la figure 2 est un schéma représentant l'agencement spatial de points de mesure formant un réseau circulaire uniforme,
- la figure 3 est un ordinogramme illustrant un exemple de mise en œuvre d'un exemple de mise en œuvre d'un procédé de caractérisation de la partie de la chambre anéchoïque,

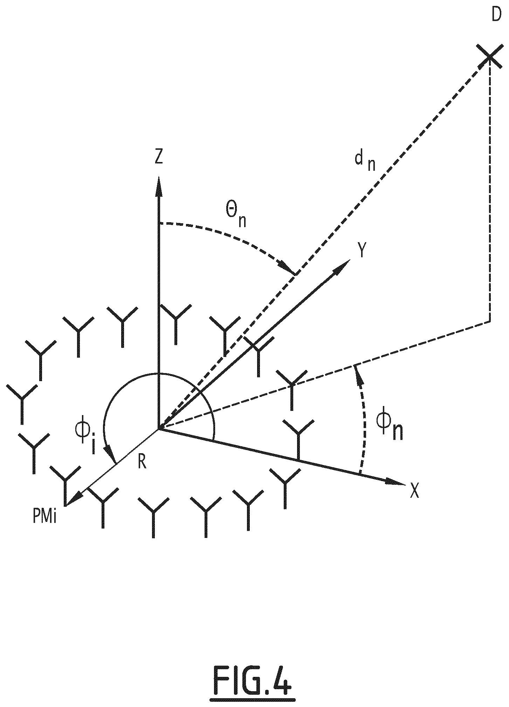

- la figure 4 est un schéma en perspective permettant de définir des grandeurs repérant le positionnement des points de mesure dans l'espace, et
- les figures 5 à 8 sont des graphes montrant des résultats obtenus par simulation par la Demanderesse par mise en œuvre d'exemples de procédé de caractérisation de la partie de la chambre anéchoïque.

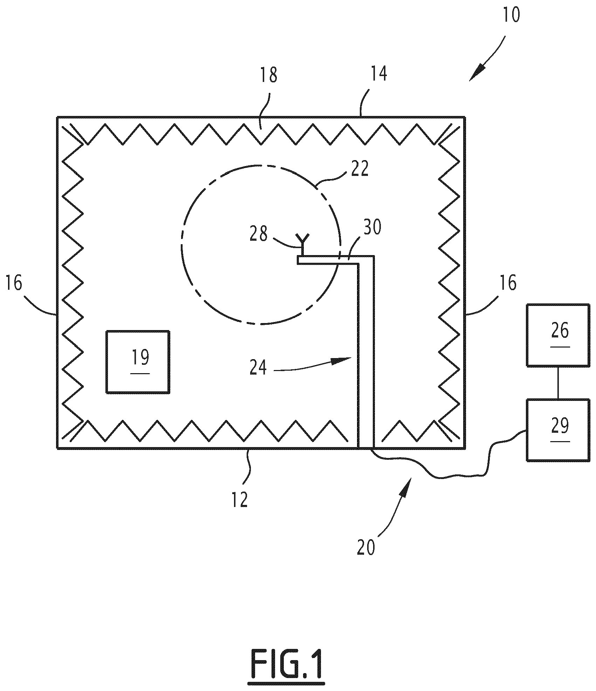

Une chambre anéchoïque 10 vue en section est représentée sur la figure 1.

La chambre anéchoïque 10 comporte un sol 12, un plafond 14 et des parois latérales 16.

Chaque paroi 12, 14 et 16 est recouverte d'un ou plusieurs absorbant(s) 18 pour absorber les ondes incidentes transmises par un émetteur 19 situé dans chambre anéchoïque 10 et ainsi rendre le milieu contenu dans l'espace délimité par les parois proche d'un espace libre sans échos.

La chambre anéchoïque 10 est pourvue d'un système de caractérisation 20 d'une partie de la chambre anéchoïque 10.

Le système de caractérisation 20 est propre à mettre en œuvre un procédé de caractérisation correspondant, ce procédé de caractérisation comportant deux phases : une phase d'acquisition P1 et une phase de détermination P2.

Le système de caractérisation 20 cherche ainsi à quantifier les imperfections de la chambre anéchoïque 10 en déterminant au moins un paramètre de caractérisation d'une partie de la chambre anéchoïque 10.

Le paramètre de caractérisation est, par exemple, un paramètre représentatif de la réflectivité, c'est-à-dire la proportion d'énergie électromagnétique réfléchie à la surface de l'absorbant 18 recouvrant chaque paroi 12, 14 et 16 de la chambre anéchoïque 10.

Plus spécifiquement, dans l'exemple décrit, le paramètre représentatif de la réflectivité est la fonction de transfert de la chambre anéchoïque 10.

La fonction de transfert de la chambre anéchoïque 10 est la fonction de transfert entre un signal émis par l'émetteur 19 et un signal reçu par un capteur 28.

De préférence, la fonction de transfert est une fonction de transfert à la fois en amplitude et en phase.

Avantageusement, la fonction de transfert est donnée pour différentes directions et différentes polarisations des ondes électromagnétiques émises.

D'autres paramètres de caractérisation sont envisageables, comme le taux d'ondes stationnaire ou l'angle d'arrivée et l'amplitude des ondes reçues.

De préférence, la partie caractérisée par le système de caractérisation 20 est la zone tranquille 22. La zone tranquille 22 est délimitée schématiquement par des pointillés sur la figure 1.

Le système de caractérisation 20 comporte un dispositif d'acquisition 24 et un dispositif de détermination 26.

Le dispositif d'acquisition 24 comporte un capteur 28, une unité d'acquisition 29 et un positionneur 30.

Dans l'exemple décrit, le capteur 28 est une antenne adaptée pour recevoir des signaux s'étendant sur une bande de fréquences prédéfinie.

Selon un exemple, la bande de fréquences prédéfinie est la bande des très hautes fréquences qui s'étend entre 30 MHz et 300 MHz.

Cette bande de fréquences est plus souvent dénommée bande VHF, l'abréviation VHF renvoyant à la dénomination anglaise correspondante de « *Very High Frequency* ».

Le capteur 28 est ainsi une antenne VHF.

Selon un autre exemple, la bande de fréquences prédéfinie est la bande des ultra-hautes fréquences qui s'étend entre 300 MHz et 3000 MHz.

Cette bande de fréquences est plus souvent dénommée bande UHF, l'abréviation UHF renvoyant à la dénomination anglaise correspondante de « *Ultra High Frequency* ».

Le capteur 28 est ainsi une antenne UHF.

Le positionneur 30 est adapté pour déplacer le capteur 28 d'un point de mesure à un autre point de mesure.

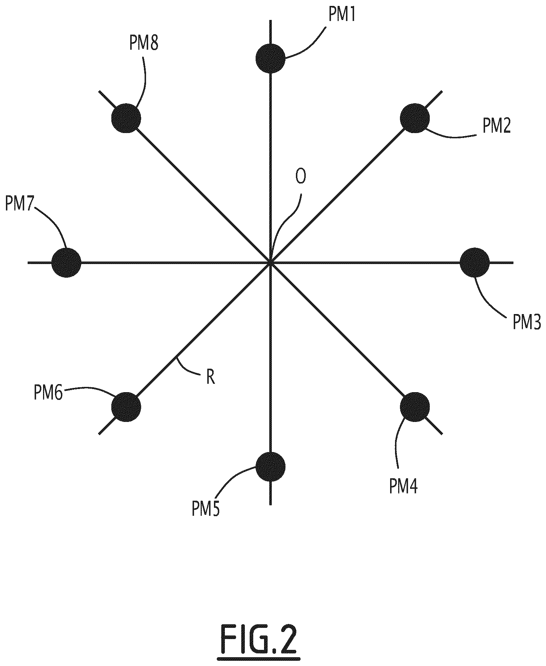

Dans l'exemple décrit, les points de mesure sont agencés comme visible sur la figure 2.

Les points de mesure comportent huit points de mesure PM1 à PM8.

Le nombre I de points de mesure est donc de 8 dans cet exemple simple mais pourrait être beaucoup plus grand, par exemple plus de 100.

Les points de mesure PM1 à PM8 sont spatialement agencés selon un cercle dont le centre est le point O sur la figure 2.

Le positionneur 30 est donc un positionneur adapté à effectuer une rotation autour d'un axe de rotation passant par le centre O. Une tel positionneur 30 est généralement disponible dans une chambre anéchoïque 10.

Le rayon du cercle est noté R dans ce qui suit.

De plus, dans l'exemple décrit, la distance entre chaque paire de points de mesure PM1 à PM8 voisins est identique.

L'ensemble des points de mesure PM1 à PM8 forme donc un réseau circulaire uniforme.

Le nombre I de points de mesure permet de déterminer un échantillonnage angulaire de l'espace. Pour un exemple de 360 points de mesure, l'échantillonnage est de 1°.

Le capteur 28 est relié à l'unité d'acquisition 29.

L'unité d'acquisition 29 est une unité d'acquisition du signal capté par le capteur 28 pour obtenir son amplitude et sa phase.

Ainsi, le dispositif d'acquisition 24 est ainsi propre à mettre en œuvre la première phase P1 du procédé de caractérisation, c'est-à-dire, pour plusieurs points de mesure PM1 à PM8, acquérir le signal électromagnétique reçu par le capteur 28 positionné audit point de mesure, pour obtenir une pluralité de signaux électromagnétiques acquis.

Le dispositif de détermination 26 est propre à déterminer au moins un paramètre de caractérisation de la zone tranquille 22 à partir des signaux acquis par le dispositif d'acquisition 24.

Le dispositif de détermination 26 est ainsi propre à obtenir les mesures acquises par le dispositif d'acquisition 24 et propre à mettre en œuvre une phase de détermination P2 du procédé de caractérisation qui sera décrit ultérieurement.

Le dispositif de détermination 26 est un calculateur.

Le dispositif de détermination 26 est ainsi un circuit électronique conçu pour manipuler et/ou transformer des données représentées par des quantités électroniques ou physiques dans des registres du calculateur et/ou des mémoires en d'autres données similaires correspondant à des données physiques dans les mémoires de registres ou d'autres types de dispositifs d'affichage, de dispositifs de transmission ou de dispositifs de mémorisation.

En tant qu'exemples spécifiques, le dispositif de détermination 26 est réalisé sous forme d'un composant logique programmable, tel qu'un FPGA (de l'anglais *Field Programmable Gate Array),* ou encore d'un circuit intégré, tel qu'un ASIC (de l'anglais *Application Specific Integrated Circuit).*

En variante, lorsque la phase de détermination P2 est réalisée sous forme d'un ou plusieurs logiciels, c'est-à-dire sous forme d'un programme d'ordinateur, également appelé produit programme d'ordinateur, il est en outre apte à être enregistré sur un support, non représenté, lisible par ordinateur. Le support lisible par ordinateur est par exemple un medium apte à mémoriser des instructions électroniques et à être couplé à un bus d'un système informatique. A titre d'exemple, le support lisible est un disque optique, un disque magnéto-optique, une mémoire ROM, une mémoire RAM, tout type de mémoire non-volatile (par exemple FLASH ou NVRAM) ou une carte magnétique. Sur le support lisible est alors mémorisé un programme d'ordinateur comprenant des instructions logicielles.

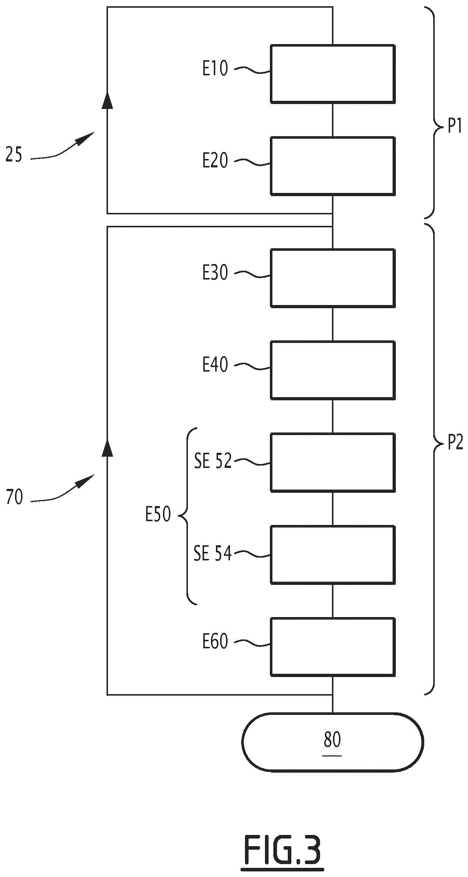

Le fonctionnement du système de caractérisation 20 est maintenant décrit en référence à la figure 3 qui illustre un exemple de mise en œuvre d'un procédé de caractérisation de la zone tranquille 22 de la chambre anéchoïque 10.

Le procédé de caractérisation cherche à caractériser la zone tranquille 22 par au moins un paramètre de caractérisation.

Dans l'exemple décrit, le paramètre de caractérisation est un paramètre représentatif de la réflectivité de la chambre anéchoïque 10.

Comme indiqué précédemment, dans cet exemple de mise en œuvre, le procédé de caractérisation comporte deux phases : une phase d'acquisition P1 et une phase de détermination P2.

La phase d'acquisition P1 comporte une succession de deux étapes : une étape de déplacement E10 et une étape d'acquisition E20.

Les deux étapes de déplacement E10 et d'acquisition E20 sont mises en œuvre pour chaque point de mesure à effectuer dans la zone tranquille 22.

Lors de l'étape de déplacement E10, le capteur 28 est positionné au point de mesure par le positionneur 30.

Le capteur 28 ainsi positionné capte ensuite le signal pour l'envoyer à l'unité d'acquisition 29.

A l'issue de la phase d'acquisition P1, il est ainsi obtenu une pluralité de signaux électromagnétiques acquis.

Il est supposé que la zone tranquille 22 peut être modélisée par un ensemble de N diffuseurs parasites émettant des signaux à destination du capteur 28 à chaque point de mesure PM1 à PM8.

Chaque diffuseur parasite (plus simplement diffuseur dans la suite) est une modélisation d'une imperfection de la chambre anéchoïque 10.

Chaque diffuseur est repéré par un entier n et présente une amplitude complexe notée $B_n$.

Chaque diffuseur n se trouve, en outre, à une distance $d_n$ par rapport au point de mesure central et à une distance $d_{n,i}$ du i-ième point de mesure PMi.

De ce fait, le signal acquis au i-ième point de mesure PMi peut s'écrire sous la forme suivante :

$$s_i = \sum_{n=1}^{N} \frac{d_n}{d_{n,i}} B_n e^{jk(d_n - d_{n,i})} + w_i$$

Où :

- $d_{n,i} = \sqrt{d_n^2 + R^2 - 2Rd_n \sin(\theta_n)\cos(\phi_n - \phi_i)}$ avec $\phi_i$ et $\phi_n$ les longitudes respectivement i-ième point de mesure PMi et du diffuseur n et $\theta_n$ la colatitude du diffuseur n (plus communément appelée direction d'arrivée), et

- $w_i$ est la contribution de bruit blanc au i-ième point de mesure PMi.

Après un développement de Taylor sur $d_{n,i}$ l'égalité suivante est obtenue :

$$d_n - d_{n,i} = R\sin(\theta_n)\cos(\phi_n - \phi_i) + \frac{R}{4d_n}(\sin(\theta_n)\cos(\phi_n - \phi_i))^2$$

**Dans une hypothèse** de diffuseur en champ lointain $d_n \to +\infty$, il vient :

$$d_n - d_{n,i} = R\sin(\theta_n)\cos(\phi_n - \phi_i)$$

Ainsi, dans cette hypothèse le signal reçu au i-ième point de mesure PMi peut s'exprimer comme suit :

$$s_i = \sum_{n=1}^{N} B_n e^{jkR\sin(\theta_n)\cos(\phi_n - \phi_i)} + w_i$$

La phase de détermination P2 a pour but de déterminer au moins un paramètre de caractérisation de la zone tranquille 22 à partir des signaux électromagnétiques acquis.

La phase de détermination P2 comporte une étape de conversion E30, une étape de filtrage E40, une étape d'estimation E50 et une étape de détermination E60.

Lors de l'étape de conversion E30, le dispositif de détermination 26 convertit les signaux électromagnétiques acquis à une fréquence donnée en un ensemble de composantes.

Chaque composante est la valeur d'un ordre respectif de la décomposition de la somme des signaux électromagnétiques acquis en modes de phase.

Dans la suite, chaque composante est notée $s_m$, l'indice m désignant l'ordre du mode de phase.

L'indice m est un nombre entier relatif pouvant prendre des valeurs entre $-\infty$ et $+\infty$. En pratique, le nombre de composantes calculées est fini.

Il est supposé dans ce qui suit que le nombre de composantes est limité par un ordre de coupure M, de sorte que les composantes d'ordre de phase m sont calculées pour toute valeur de m comprise entre -M et +M.

Il est néanmoins à noter qu'il est possible de calculer plus de composantes et de ne considérer que les composantes d'un mode de phase présentant un ordre inférieur ou égal en valeur absolue à M lors de l'étape d'estimation E50.

Le dispositif de détermination 26 réalise la conversion au moins par l'application d'une transformée de Fourier inverse pour obtenir les composantes.

La transformée de Fourier inverse est, par exemple, appliquée sur un vecteur obtenu par un traitement des signaux acquis.

Le traitement comporte au moins un échantillonnage de la multiplication des signaux acquis.

En complément, le traitement peut également comporter un filtrage, notamment un filtrage passe-bas, et/ou une conversion vers une bande de fréquences plus faibles.

De fait, par définition, la composante du mode de phase m est donnée par l'expression suivante :

$$s_{\mathrm{m}} = \frac{1}{I} \sum_{n=1}^{N} s_i e^{jm\phi_i}$$

Les composantes de chaque mode de phase s'écrivent :

$$s_{\mathrm{m}} = \sum_{n=1}^{N} B_n \sum_{p=-\infty}^{+\infty} j^p J_p(kR\sin(\theta_n)) e^{jp\phi_n} \sum_{i=1}^{I} \frac{e^{j(m-p)\phi_i}}{I}$$

Où:

- j désigne le nombre complexe tel que $j^2 = -1$,
- $J_p$ est la p-ième fonction de Bessel de première espèce, et
- $k$ est le nombre d'onde.

Cette expression est obtenue en omettant le bruit blanc gaussien pour simplifier la notation et en utilisant l'identité de Jacobi-Anger selon laquelle :

$$e^{jkR\sin(\theta_n)\cos(\phi_n - \phi_i)} = \sum_{p=-\infty}^{+\infty} j^p J_p(kR\sin(\theta_n)) e^{jp(\phi_n - \phi_i)}$$

L'expression précédente de $s_{\mathrm{m}}$ peut être simplifiée en remarquant que $\sum_{i=1}^{I} \frac{e^{j(m-p)\phi_i}}{I} = 1$ si seulement si $p - m = Iz$ où z est un entier quelconque.

Or, le terme $J_p(kR\sin(\theta_n))$ décroit fortement vers 0 lorsque $z \neq 0$. Il vient alors pour z = 0

$$s_{\mathrm{m}} = \sum_{n=1}^{N} B_n j^m J_m(kR\sin(\theta_n)) e^{jm\phi_n}$$

A l'issue de l'étape de conversion E30, le dispositif de détermination 26 dispose donc d'un ensemble de composantes $s_{\mathrm{m}}$.

Les composantes $\{s_{\mathrm{m}}\}_{m \in [-M,M]}$ ainsi obtenues présentent la particularité de dépendre de la fréquence (via la présence du nombre d'onde).

L'étape de filtrage E40 vise à éliminer cette dépendance en fréquence.

Pour cela, lors de l'étape de filtrage E40, le dispositif de détermination 26 applique sur chaque composante un filtre de compensation éliminant la dépendance en fréquence de la composante, pour obtenir des composantes filtrées.

Le filtre de compensation est noté w dans la suite et chaque composante filtrée est notée $sw_{\mathrm{m}}$.

Dans un mode de réalisation, le filtre de compensation w appliqué s'exprime comme suit :

$$W_m = \frac{1}{j^m J_m(kR)}$$

où $W_m$ désigne la valeur du filtre appliqué sur la composante m. Il vient ainsi :

$$sw_m = W_m s_m$$

L'expression précédente correspond ainsi à la relation suivante :

$$sw_m = W_m \sum_{n=1}^{N} B_n j^m J_m(kR\sin(\theta_n)) e^{jm\phi_n}$$

**Dans le cadre** d'une hypothèse de diffuseurs appartenant au plan du cercle, c'est-à-dire que $\theta_n = 90° \; \forall n \in N$, la composante indépendante de la fréquence pour chaque mode de phase peut s'écrire :

$$sw_m = \sum_{n=1}^{N} B_n z_n^m$$

où $z_n$ **sont** les pôles tels que $z_n = e^{j\phi_n}$,

Le filtre de compensation w rend bien les composantes en mode de phase uniquement dépendante de l'amplitude complexe $B_n$ et des directions d'arrivée $\phi_n$ sans dépendance en fréquence.

Selon une variante plus élaborée, filtre de compensation w appliqué s'exprime comme suit :

$$W_m = \frac{1}{j^m\left(J_m(kR) - jJ_m'(kR)\right)}$$

Où $J_m'$ **désigne** la dérivée de la m-ième fonction de Bessel de première espèce.

Un tel filtre de compensation w est notamment adapté pour des diffuseurs se situant hors du plan du cercle, c'est-à-dire lorsque $\theta_n \neq 90°$.

A l'issue des étapes de conversion E30 et de filtrage E40, le dispositif de détermination 26 dispose ainsi d'un ensemble de composantes filtrés $\{sw_m\}_{m \in [-M,M]}$ pour chaque ordre de mode de phase.

L'étape d'estimation E50 vise à obtenir les caractéristiques de chaque diffuseur n, à savoir la direction d'arrivée et les amplitudes complexes $B_n$.

L'étape d'estimation E50 est mise en œuvre par résolution d'un système d'équations selon lequel chaque composante filtrée $sw_m$ est égale à une somme de contributions des diffuseurs à la valeur de la composante filtrée $sw_m$.

Comme cela apparaîtra plus précisément à la lecture de la suite, il s'agit ici de la résolution du système d'équations formé par les M équations issues correspondant à l'égalité suivante :

$$sw_m = \sum_{n=1}^{N} B_n z_n^m$$

Du fait d'une telle forme, une telle résolution revient ici à la mise en œuvre d'une technique de recherche de pôles (les $z_n$) appelée la méthode du crayon matriciel et d'un pré-filtrage du bruit blanc (avant la mise en œuvre de la technique de recherche).Les solutions du système d'équations sont les amplitudes estimées $B_n$ et des directions d'arrivée estimées $\phi_n$.

La contribution d'un diffuseur parasite dépend de l'amplitude $B_n$ et de la direction d'arrivée $\phi_n$ du diffuseur.

Comme indiqué précédemment, selon l'exemple décrit, chaque contribution est égale au produit de l'amplitude $B_n$ par une exponentielle complexe dont l'argument est la direction d'arrivée $\phi_n$.

Cela conduit pour chaque composante filtrée à une équation correspondant à une somme d'exponentielles complexes, à savoir :

$$sw_{m} = \sum_{n=1}^{N} B_n \left( e^{j\phi_n} \right)^m$$

Dans le cas de la figure 3, l'étape d'estimation E50 comporte deux sous-étapes, à savoir une sous-étape de recherche SE52 et une sous-étape d'obtention SE54.

Lors de la sous-étape de recherche SE52, le dispositif de détermination 26 recherche la valeur des pôles par mise en œuvre d'une technique de recherche de pôles.

Dans l'exemple décrit, la technique de recherche de pôles est une technique de crayon matriciel.

Une technique de crayon matriciel permet d'extraire une information, ici les valeurs des directions d'arrivées, dans une somme d'exponentielles complexes (cissoïdes).

La technique de crayon matriciel cherche à estimer les valeurs propres généralisées d'une paire de matrices. Un tel problème de valeurs propres généralisées consiste en trouver un vecteur *V* vérifiant :

$$H_2 V = \lambda . H_1 V$$

Où:

- $H_1$ et $H_2$ sont les deux matrices constituant la paire de matrices. Ces matrices sont généralement appelés matrices de Henkel,
- $\lambda$ est un scalaire appelé valeur propre généralisée de $H_1$ et $H_2$, et
- v est le vecteur propre généralisé de $H_1$ et $H_2$.

La technique de crayon matriciel implique ainsi l'emploi d'une première matrice de Henkel $H_1$ et d'une deuxième matrice de Henkel $H_2$.

Selon un exemple, les matrices de Henkel $H_1$ et $H_2$ sont construites comme suit. La première matrice $H_1$ s'écrit ainsi :

$$H_1 = \begin{pmatrix} sw_{-M} & \cdots & sw_{L-1} \\ \vdots & \ddots & \vdots \\ sw_{M-L-1} & \cdots & sw_{M-1} \end{pmatrix}$$

Où:

- L est le paramètre de crayon. Le paramètre de crayon L est, en général, pris égal à 0 à cause de l'indexation symétrique du signal une fois transformé en modes de phase.

La deuxième matrice $H_2$ s'écrit ainsi :

$$H_2 = \begin{pmatrix} sw_{-M+1} & \cdots & sw_L \\ \vdots & \ddots & \vdots \\ sw_{M-L} & \cdots & sw_M \end{pmatrix}$$

Il est alors possible de montrer que, lorsque $-M + N \leq L \leq M - N$, avec au minimum $N \leq M$, les valeurs propres généralisées de la paire de matrices [H2, H1] sont les pôles $z_n$.

Le dispositif de détermination 26 recherche ainsi les valeurs des pôles en calculant les valeurs propres généralisées de la paire de matrices [H2, H1].

Selon un exemple plus élaboré, un seuillage des valeurs de chacune des matrices de Henkel pour éliminer les valeurs présentant du bruit, les valeurs étant éliminées lorsque ces valeurs ne respectent pas une condition par rapport à un seuil prédéterminé lié au bruit.

A titre d'illustration d'un exemple de mise en œuvre d'une telle technique de seuillage, une matrice intermédiaire H est construite comme suit :

$$H = \begin{pmatrix} s_{-M} & \cdots & s_L \\ \vdots & \ddots & \vdots \\ s_{M-L-1} & \cdots & s_{M-1} \end{pmatrix}$$

Un seuillage des valeurs singulières au-dessus d'un certain seuil est effectué, pour éliminer les valeurs de la matrice intermédiaire H qui sont bruitées (elles sont mises à 0).

Pour cela, il est avantageux de choisir un seuil inversement proportionnel au rapport signal sur bruit.

Les matrices $H_1$ et $H_2$ comportent alors des valeurs nulles pour les valeurs bruitées.

Une telle technique permet d'éliminer efficacement la présence de bruits dans l'acquisition des signaux.

Lors de la sous-étape d'obtention SE54, le dispositif de détermination 26 obtient les amplitudes complexes $B_n$.

Pour cela, le dispositif de détermination 26 cherche les valeurs d'amplitudes complexes $B_n$ permettant d'obtenir un ajustement entre les valeurs de l'ensemble de composantes indépendantes de la fréquence $\{sw_m\}_{m \in [-M,M]}$ d'une part et la somme $\left\{\sum_{n=1}^{N} B_n z_n^m\right\}_{m \in [-M,M]}$.

Toute technique d'optimisation permettant de réaliser un tel ajustement est envisageable ici.

Ainsi, selon un exemple, le dispositif de détermination 26 applique une technique de moindre carré pour estimer les amplitudes $B_n$.

A l'issue de l'étape d'estimation E50, le dispositif de détermination 26 dispose ainsi, pour chaque diffuseur, d'une estimation de son amplitude $B_n$ et de sa direction d'arrivée $\phi_n$.

Lors de l'étape de détermination E60, le dispositif de détermination 26 déduit à partir des éléments ainsi obtenus un paramètre de caractérisation de la zone tranquille 22.

Ici, le dispositif de détermination 26 calcule le paramètre représentatif de la réflectivité de la zone tranquille 22 en déterminant les amplitudes des ondes présentes lorsque les diffuseurs ayant les propriétés déterminées à l'étape d'estimation E50 sont présents.

Plus précisément, le dispositif de détermination 26 obtient ici la fonction de transfert de la chambre anéchoïque 10.

Selon l'exemple décrit, les étapes de conversion E30, de filtrage E40, d'estimation E50 et de détermination E60 sont mises en œuvre pour plusieurs fréquences pour obtenir la variation en fréquence du paramètre de caractérisation.

Cela est représenté schématiquement par une flèche 70 sur la figure 3 et le bloc 80 correspondant au résultat, c'est-à-dire la variation en fréquence du paramètre de caractérisation.

Les fréquences utilisées à chaque itération sont déterminées en fonction de la bande de fréquences que l'on souhaite caractériser pour la zone tranquille 22 à caractériser.

Le procédé de caractérisation qui vient d'être décrit permet d'obtenir des bonnes performances de caractérisation de la zone tranquille 22 à caractériser.

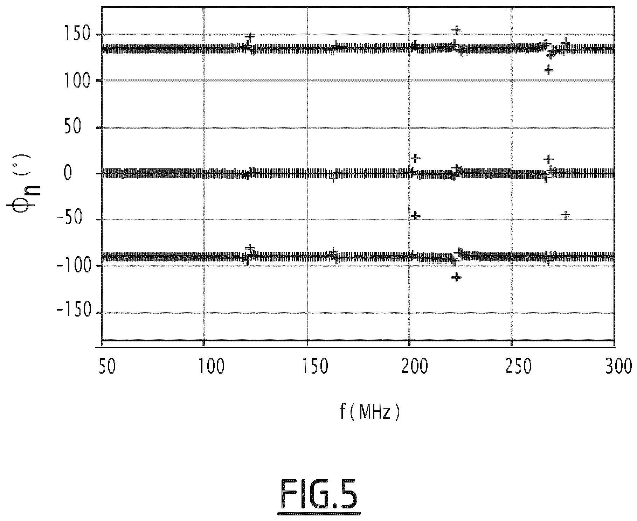

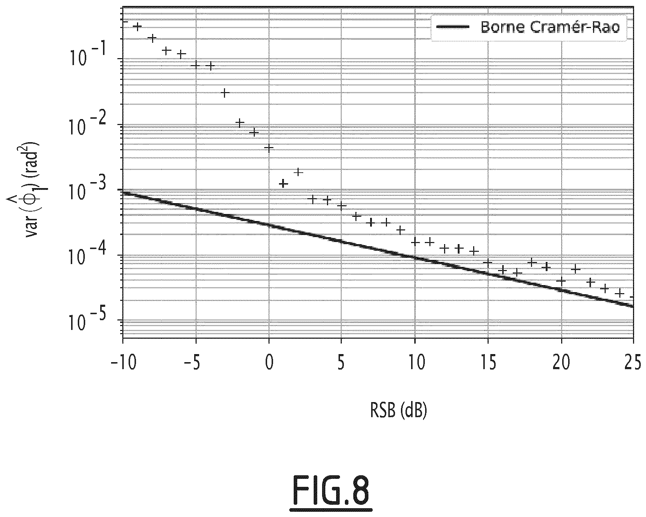

Cela a été démontré par la Demanderesse à travers plusieurs simulations dont les résultats sont visibles aux figures 5 à 8.

Une première simulation vise à montrer qu'il est possible de réaliser une détection de plusieurs diffuseurs.

Dans cette simulation, il est supposé que trois diffuseurs sont présents en champ lointain dans le plan du cercle, avec respectivement les angles $\phi_1 = 0°$, $\phi_2 = -90°$ et $\phi_3 = 135°$

Les signaux reçus sont de même amplitude complexe constante sur l'ensemble de la bande avec un rapport signal à bruit (RSB) de 20 dB.

Le rayon du cercle est de 1.5 m avec un échantillonnage angulaire de 1°.

La bande de fréquence d'intérêt va de 50 MHz jusqu'à 300 MHz.

Dans ce cadre de diffuseurs dans le plan du cercle, le filtre de compensation

$$W_m = \frac{1}{j^m J_m(kR)}$$

est utilisé.

La mise en oeuvre du procédé permet d'obtenir les résultats de la figure 5 qui représente l'estimation des trois angles $\phi_n$ sur la bande de fréquence d'intérêt.

L'estimation des angles est correctement réalisée sur la bande de fréquence considérée. Quelques points en fréquences montrent un décrochage dans l'estimation, cela vient de la sensibilité du filtre à la présence de termes nuls dans les fonctions de Bessel de première espèce en certains points.

Une deuxième simulation vise à étudier l'influence de la colatitude dans le même montage que précédemment.

La deuxième simulation repose cette fois sur la présence d'un unique diffuseur dont l'angle d'arrivée $\phi_1$ est arbitrairement fixé à 0° et son élévation $\theta_1$ varie de 90° à 180°.

L'estimation se fait à une seule fréquence arbitrairement fixée à 100 MHz.

Mais les résultats ne se limitent pas à cette seule fréquence, grâce à la stabilité fréquentielle démontrée en lien avec la première simulation (voir figure 5).

Dans le cadre de la deuxième simulation, il est utilisé le filtre de compensation suivant :

$$W_m = \frac{1}{j^m\left(J_m(kR) - jJ_m^{'}(kR)\right)}$$

**Cela se justifie** par le fait qu'il faut compenser l'élévation introduite par la variation de la colatitude $\theta_1$.

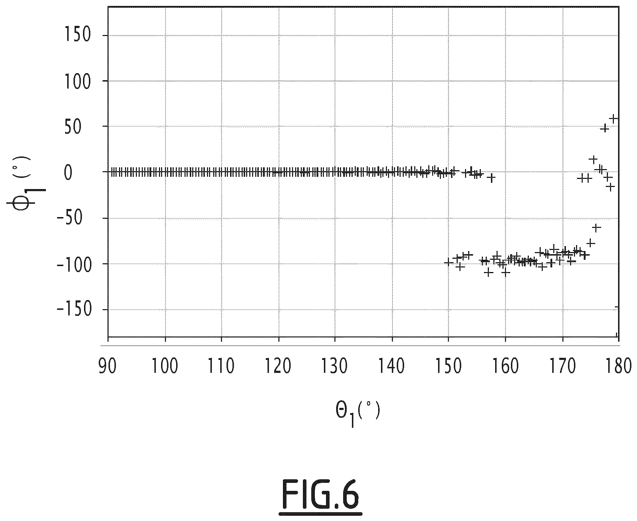

La mise en œuvre du procédé permet d'obtenir les résultats de la figure 6 qui représente l'estimation à 100 MHz de l'angle d'arrivée $\phi_1$ en fonction de la colatitude $\theta_1$.

Il apparaît que pour des angles d'élévations allant jusqu'à 150°, l'estimation est juste. Cela montre la robustesse de l'estimation de la composante longitudinale $\phi$ par rapport aux à des cas où les diffuseurs non situés dans le plan du cercle. Autrement formulé, le procédé est bien applicable quelle que soit la position des diffuseurs (dans ou hors du plan du cercle).

Une troisième simulation a également été réalisée pour déterminer l'influence du bruit, celle-ci ayant été négligée dans certaines hypothèses formulées précédemment.

Cette troisième simulation part du constat que les première et deuxième simulations ont été réalisées en supposant que le signal reçu présente un rapport signal à bruit de 20 dB, ce qui peut ne pas être le cas en pratique. Il s'agit ainsi d'analyser la variance de l'estimateur pour un diffuseur donné en fonction du rapport signal à bruit.

Le modèle de diffusion est similaire à celui de la deuxième simulation sauf que le diffuseur est supposé dans le plan du cercle. La partie longitudinale de la direction d'arrivée est fixée arbitrairement à $\phi_1 = 0°$.

1000 simulations de Monte-Carlo sont générées à chaque niveau de bruit considéré. Le rapport signal à bruit varie de -10 dB à 25 dB et l'estimation est réalisée à 100 MHz.

Les estimations de la direction d'arrivée en fonction du rapport signal à bruit sont représentées sur la Figure 5. Conformément à ce qui est attendu, l'incertitude liée à l'estimation se réduit à mesure que le rapport signal à bruit augmente. Plus précisément, l'incertitude est inférieure à +/-25° pour un rapport signal à bruit de 5 dB et descend jusqu'à atteindre une valeur inférieure à 1° lorsque le rapport signal à bruit vaut 25 dB.

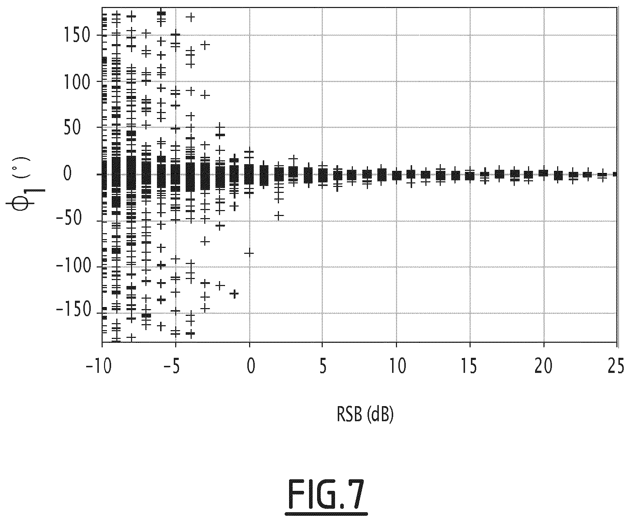

La figure 7 illustre la variation de la variance de l'estimation de la direction d'arrivée en fonction du rapport signal à bruit (points formés par une croix). Dans le même graphe, la borne de Cramér-Rao est également représentée. Cette borne correspond à la limite théorique de variance pouvant être obtenue pour un estimateur sans biais. Plus le rapport signal à bruit augmente et plus la variance diminue jusqu'à se rapprocher fortement de la limite de Cramér-Rao pour des rapports signal à bruit supérieurs à 5 dB. Le procédé permet donc de fonctionner même avec des signaux présentant un rapport signal à bruit de 5 dB.

Le procédé de caractérisation permet ainsi une évaluation plus précise des performances de la chambre et un étalonnage du matériel de test.

En outre, le procédé permet d'estimer avec précision les paramètres des réflexions même en présence de bruit. Les expériences précédentes montrent, en effet, une bonne robustesse du procédé.

De fait, le procédé de caractérisation est un procédé pouvant opérer avec une haute résolution, le nombre de points de mesure pouvant aisément être augmenté.

Le procédé est utilisable avec des antennes à bande étroite généralement utilisés pour les fréquences VHF ou UHF.

De plus, le procédé utilise un positionneur en rotation qui est nativement disponible dans la plupart des chambres anéchoïques 10, de sorte que l'opération de décalpination (enlever une partie des absorbants 18) n'est pas nécessaire.

Les calculs à effectuer par le dispositif de détermination 26 sont, en outre, relativement peu consommateur de temps grâce notamment à l'emploi de la technique de crayon matriciel.

Il en résulte que le procédé est de mise en œuvre plus aisée tout en permettant d'obtenir une caractérisation plus précise de la zone tranquille 22.

D'autres modes de réalisation du présent procédé bénéficiant de ces avantages sont envisageables.

En particulier, il serait possible que les points de mesure soient agencés selon plusieurs cercles concentriques.

En variante, les points de mesure sont agencés selon plusieurs cercles appartenant à des plans différents, notamment des plans parallèles (les cercles étant alors superposés).

Le procédé fonctionne pour tout type de capteur 28.

En particulier, il peut être envisagé de réaliser physiquement le réseau circulaire en positionnant une antenne à chaque point de mesure.

**Revendications**

**1.** Procédé de caractérisation d'une partie (22) d'une chambre anéchoïque (10), le procédé de caractérisation comprenant :

- une phase d'acquisition comprenant :

- pour plusieurs points de mesure (PM1, PM2, PM3, PM4, PM5, PM6, PM7, PM8) dans la partie (22), une étape d'acquisition d'un signal électromagnétique reçu par un capteur (28) positionné audit point de mesure (PM1, PM2, PM3, PM4, PM5, PM6, PM7, PM8), pour obtenir une pluralité de signaux électromagnétiques acquis,
les points de mesure (PM1, PM2, PM3, PM4, PM5, PM6, PM7, PM8) étant spatialement agencés selon un cercle,

- une phase de détermination d'au moins un paramètre de caractérisation de la partie (22) à partir des signaux électromagnétiques acquis, la phase de détermination comprenant une étape de :

- conversion des signaux électromagnétiques acquis à une fréquence donnée en un ensemble de composantes, chaque composante étant la valeur d'un ordre respectif de la décomposition de la somme des signaux électromagnétiques acquis en modes de phase,
- filtrage de chaque composante par application d'un filtre de compensation sur chaque composante éliminant la dépendance en fréquence de la composante, pour obtenir des composantes filtrées,
- estimation de l'amplitude et de la direction d'arrivée de chacun des diffuseurs parasites présents dans la chambre anéchoïque (10) par résolution d'un système d'équations selon lequel chaque composante filtrée est égale à une somme de contributions de diffuseurs parasites à la valeur de la composante filtrée, la contribution d'un diffuseur parasite dépendant de l'amplitude et de la direction d'arrivée du diffuseur, pour obtenir des amplitudes estimées et des directions d'arrivée estimées, et
- détermination de la valeur d'au moins un paramètre de caractérisation à la fréquence donnée à partir des amplitudes estimées et des directions d'arrivée estimées.

2. Procédé de caractérisation selon la revendication 1, dans lequel un unique capteur (28) est utilisé lors de la mise en œuvre de la phase d'acquisition, la phase d'acquisition comportant une étape de déplacement du capteur (28) vers chaque point de mesure (PM1, PM2, PM3, PM4, PM5, PM6, PM7, PM8).

3. Procédé de caractérisation selon la revendication 1 ou 2, dans lequel chaque capteur (28) est une antenne adaptée pour recevoir des signaux s'étendant sur une bande de fréquences prédéfinie, la bande de fréquences prédéfinie étant incluse dans l'intervalle s'étendant entre 30 MHz et 3 000 MHz.

4. Procédé de caractérisation selon l'une quelconque des revendications 1 à 3, dans lequel le paramètre de caractérisation est le taux d'ondes stationnaire ou un paramètre représentatif de la réflectivité de la chambre anéchoïque (10).

5. Procédé de caractérisation selon l'une quelconque des revendications 1 à 4, dans lequel, lors de la phase de détermination, les étapes de conversion, de filtrage, d'estimation et de détermination sont mises en œuvre pour plusieurs fréquences pour obtenir la variation en fréquence du paramètre de caractérisation.

6. Procédé de caractérisation selon l'une quelconque des revendications 1 à 5, dans lequel chaque contribution est égale au produit de l'amplitude par une exponentielle complexe dont l'argument est la direction d'arrivée.

7. Procédé de caractérisation selon l'une quelconque des revendications 1 à 6, dans lequel l'étape d'estimation comporte la mise en œuvre d'une technique de crayon matriciel pour estimer les directions d'arrivées.

8. Procédé de caractérisation selon la revendication 7, dans lequel la technique de crayon matriciel implique l'emploi d'une première matrice de Henkel et d'une deuxième matrice de Henkel, la première matrice de Henkel étant telle que

$$H_1 = \begin{pmatrix} sw_{-M} & \cdots & sw_{L-1} \\ \vdots & \ddots & \vdots \\ sw_{M-L-1} & \cdots & sw_{M-1} \end{pmatrix}$$

où                                                                    :

• $sw_x$ désigne la composante filtrée d'ordre x,
• $M$ désigne l'ordre maximal des composantes obtenues à l'étape de conversion, et
• L est le paramètre de crayon,

$$H_2 = \begin{pmatrix} sw_{-M+1} & \cdots & sw_L \\ \vdots & \ddots & \vdots \\ sw_{M-L} & \cdots & sw_M \end{pmatrix}$$

la deuxième matrice $H_2$ étant telle que $\qquad\qquad\qquad\qquad\qquad\qquad$ .

9. Procédé de caractérisation selon la revendication 8, dans lequel la technique de crayon matriciel comporte un seuillage des valeurs de chacune des matrices de Henkel pour éliminer les valeurs présentant du bruit, les valeurs étant éliminées lorsque ces valeurs ne respectent pas une condition par rapport à un seuil prédéterminé.

10. Procédé de caractérisation selon l'une quelconque des revendications 1 à 9, dans lequel l'étape d'estimation comporte l'application d'une technique de moindre carré pour estimer les amplitudes.

11. Procédé de caractérisation selon l'une quelconque des revendications 1 à 10, dans lequel il est défini une zone tranquille (22) pour la chambre anéchoïque (10), la partie **caractérisée par** le procédé de caractérisation étant la zone tranquille (22).

12. Dispositif de détermination (26) d'au moins un paramètre de caractérisation d'une partie d'une chambre anéchoïque (10), le dispositif de détermination (26) étant propre à :

- obtenir, pour plusieurs points de mesure ( PM1, PM2, PM3, PM4, PM5, PM6, PM7, PM8) dans la partie (22), un signal électromagnétique acquis, chaque signal électromagnétique étant le signal électromagnétique reçu par un capteur (28) positionné audit point de mesure (PM1, PM2, PM3, PM4, PM5, PM6, PM7, PM8), les points de mesure (PM1, PM2, PM3, PM4, PM5, PM6, PM7, PM8) étant spatialement agencés selon un cercle,
- déterminer au moins un paramètre de caractérisation de la partie (22) à partir des signaux acquis par :

- conversion des signaux électromagnétiques acquis à une fréquence donnée en un ensemble de composantes, chaque composante étant la valeur d'un ordre respectif de la décomposition de la somme des signaux électromagnétiques acquis en modes de phase,
- filtrage de chaque composante par application d'un filtre de compensation sur chaque composante éliminant la dépendance en fréquence de la composante, pour obtenir des composantes filtrées,
- estimation de l'amplitude et de la direction d'arrivée de chacun des diffuseurs parasites présents dans la chambre anéchoïque (10) par résolution d'un système d'équations selon lequel chaque composante filtrée est égale à une somme de contributions de diffuseurs parasites à la valeur de la composante filtrée, la contribution d'un diffuseur parasite dépendant de l'amplitude et de la direction d'arrivée du diffuseur, pour obtenir des amplitudes estimées et des directions d'arrivée estimées, et
- déduction de la valeur d'au moins un paramètre de caractérisation à la fréquence donnée à partir des amplitudes estimées et des directions d'arrivée estimées.

13. Système de caractérisation (20) d'une partie (22) d'une chambre anéchoïque (10), le système de caractérisation (20) comportant :

- un dispositif d'acquisition (24), le dispositif d'acquisition (24) comprenant au moins un capteur (28), le dispositif d'acquisition (24) étant propre à, pour plusieurs points de mesure ( PM1, PM2, PM3, PM4, PM5, PM6, PM7, PM8) dans la partie (22), acquérir un signal électromagnétique acquis, chaque signal électromagnétique étant le signal électromagnétique reçu par un capteur (28) positionné audit point de mesure ( PM1, PM2, PM3, PM4, PM5, PM6, PM7, PM8), les points de mesure (PM1, PM2, PM3, PM4, PM5, PM6, PM7, PM8) étant spatialement agencés selon un cercle, et
- un dispositif de détermination (26), le dispositif de détermination (26) étant selon la revendication 12.

14. Chambre anéchoïque (10) pourvue d'un système de caractérisation (20) d'une partie (22) d'une chambre anéchoïque (10), le système de caractérisation (20) étant selon la revendication 13.

**FIG.1**

PM1
PM8
O
PM2
PM7
PM3
R
PM6
PM4
PM5

FIG.2

FIG.3

FIG.4

FIG.5

## FIG.6

FIG.7

FIG.8

# EP 4 660 641 A1

## RAPPORT DE RECHERCHE EUROPEENNE

Numéro de la demande

EP 25 18 0627

Europäisches Patentamt
European Patent Office
Office européen des brevets

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2020/271709 A1 (DERAT BENOÎT [DE]) 27 août 2020 (2020-08-27) * alinéa [0056] - alinéa [0080] * * alinéa [0005] * | 1-14 | INV. G01R29/08 G01R35/00 |
| A | 3GPP DRAFT; APPENDIX F TEXT CHANGE OF 25 914 V1 0 0, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, vol. RAN WG4, no. Denver, USA; 20060206, 6 février 2006 (2006-02-06), XP050175068, * Section F.2 * | 1-14 | |
| A | MUNOZ FREDERIC ET AL: "Anechoic Chamber Reflectivity Analyses below its minimal frequency using the Matrix Pencil Method", 2021 IEEE CONFERENCE ON ANTENNA MEASUREMENTS & APPLICATIONS (CAMA), IEEE, 15 novembre 2021 (2021-11-15), pages 165-168, XP034084007, DOI: 10.1109/CAMA49227.2021.9703583 * Sections I, II * | 1-14 | DOMAINES TECHNIQUES RECHERCHES (IPC) G01R |
| A | CHEN ZHONG ET AL: "Determination of Antenna Displacement from a Single Cut Quasi-Farfield Pattern for Cylindrical Mode Filtering Applications", 2023 17TH EUROPEAN CONFERENCE ON ANTENNAS AND PROPAGATION (EUCAP), EUROPEAN ASSOCIATION FOR ANTENNAS AND PROPAGATION, 26 mars 2023 (2023-03-26), pages 1-5, XP034352246, DOI: 10.23919/EUCAP57121.2023.10133308 * Section II * | 1-14 | |

-/--

Le présent rapport a été établi pour toutes les revendications

| Lieu de la recherche | Date d'achèvement de la recherche | Examinateur |
|---|---|---|
| Munich | 6 juin 2025 | Meliani, Chafik |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.......................................................................
& : membre de la même famille, document correspondant

EPO FORM 1503 03.82 (P04C02)

page 1 de 2

Europäisches
Patentamt

European
Patent Office

Office européen
des brevets

**RAPPORT DE RECHERCHE EUROPEENNE**

**Numéro de la demande**

**EP 25 18 0627**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | CHEN ZHONG ET AL: "Intercomparisons of Site VSWR Measurement Methods using Mode Filtering, Time Domain and Spatial Sampling Techniques", 2021 ANTENNA MEASUREMENT TECHNIQUES ASSOCIATION SYMPOSIUM (AMTA), AMTA, 24 octobre 2021 (2021-10-24), pages 1-6, XP034039186, DOI: 10.23919/AMTA52830.2021.9620661 * abrégé * ----- | 1-14 | |
| A | N/A: "Calibrated Over Air Test Environment Proposed Draft Text", IEEE DRAFT; 11-06-0760-01-000T-CALIBRATED-OVER-AIR-TEST-ENVIRONMENT-PROPOSED-DRAFT-TEXT, IEEE-SA MENTOR, PISCATAWAY, NJ USA, vol. 802.11T, no. 1, 14 juillet 2006 (2006-07-14), pages 1-18, XP017687001, * abrégé * ----- | 1-14 | |
| A | EP 3 748 375 B1 (ROHDE & SCHWARZ [DE]) 24 mai 2023 (2023-05-24) * revendication 1 * ----- | 1-14 | **DOMAINES TECHNIQUES RECHERCHES (IPC)** |
| A | CN 117 783 699 A (CETC SIYI TECH CO LTD) 29 mars 2024 (2024-03-29) * revendication 1 * ----- | 1-14 | |

Le présent rapport a été établi pour toutes les revendications

| Lieu de la recherche | Date d'achèvement de la recherche | Examinateur |
|---|---|---|
| Munich | 6 juin 2025 | Meliani, Chafik |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

page 2 de 2

**ANNEXE AU RAPPORT DE RECHERCHE EUROPEENNE
RELATIF A LA DEMANDE DE BREVET EUROPEEN NO.**

EP 25 18 0627

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-06-2025

| Document brevet cité au rapport de recherche | Date de publication | Membre(s) de la famille de brevet(s) | Date de publication |
|---|---|---|---|
| US 2020271709 A1 | 27-08-2020 | AUCUN | |
| EP 3748375 B1 | 24-05-2023 | CN 112051456 A<br>EP 3748375 A1<br>US 2020386800 A1 | 08-12-2020<br>09-12-2020<br>10-12-2020 |
| CN 117783699 A | 29-03-2024 | AUCUN | |

EPO FORM P0460

Pour tout renseignement concernant cette annexe : voir Journal Officiel de l'Office européen des brevets, No.12/82